# EUROPEAN PATENT APPLICATION

(11) **EP 2 849 100 A1**
(43) Date of publication of application: **18.03.2015**
(21) Application number: 14185227.7
(22) Date of filing: 17.09.2014
(51) Int. Cl.: G06F 17/50

(54) **System and method for bi-directional coupling of finite analysis solvers**

(30) Priority: 17.09.2013 IN CH41682013
(71) Applicant: Airbus India Operations PVT Ltd, 560048 Bangalore (IN)
(72) Inventor: Mishra, Shreesh, 560048 Bangalore (IN); Divine, Raymond, Bristol, Bristol BS99 7AR (GB); Turaga Sriramakrishna, 560048 Bangalore (IN); Reddy, Madhusudhana, 560048 Bangalore (IN)
(74) Representative: Ribeiro, James Michael

(57) **Abstract**

A system and method for bi-directional coupling of commercially available finite analysis solvers is disclosed. The method involves configuring a solver specific service for each of the finite analysis solvers and further configuring a task scheduling service (TSS) to facilitate the transfer of solver dependent boundary conditions or file loads between the two finite analysis solvers. Transient coupling is performed between the two finite analysis solvers while mapping data back and forth between them.

## Description

### FIELD OF TECHNOLOGY

Embodiments of the present subject matter relate generally to finite analysis, and more particularly to coupling of finite analysis solvers for multi-disciplinary simulations.

### BACKGROUND

Finite analysis or numerical solvers that provide solutions to specific problems are commercially available. For example, finite analysis solver "Fluent®" is available for Computational Fluid Dynamics (CFD) and "Ansys Mechanical®" is available for Finite Element Analysis (FEA) - Mechanical and Thermal. Typically in industrial applications, it is required to sequentially couple two different finite analysis solvers for multi-disciplinary simulations. For example, CFD-FEA coupling may be required for fluid structural interaction (FSI) applications. In such a coupled simulation scenario, one of the finite analysis solvers may be used as a leading finite analysis solver. In the example of CFD-FEA coupling, "Fluent®" may be used as the leading finite analysis solver for CFD analysis and "Ansys Mechanical®" may be used as the second finite analysis solver for FEA-Thermal analysis. In this case, the output data from the CFD solver may be used by a thermal model in "Ansys Mechanical®" as new loads or boundary conditions and vice versa. Generally, this process continues till the sequential coupling of finite analysis solvers/simulation is performed for the entire computational/simulation period.

For strongly coupled and time-varying phenomena, it is required to perform transient or time-varying computations while mapping data back and forth from one finite analysis solver to another iteratively. Multiple coupling iteration loops may be required between the two finite analysis solvers as they progress in time.

Further, the existing solutions require the time instances at which coupling needs to be performed and the time-step sizes of the coupling steps to be fixed. However, for some duration during simulation, the two finite analysis solvers may need to be coupled as frequently as possible to improve the computational efficiency; while for remaining time duration, the finite analysis solvers may have to be coupled with reduced frequency based on user requirements to reduce computational costs.

Furthermore for an optimized simulation activity, the two finite analysis solvers may require significantly different mesh configurations (for example, mesh size and element type) for different domains. The finite analysis solvers may also have different computational hardware or platform requirements. Therefore, the finite analysis solvers may need to run on different servers, different operating systems and/or different processors at different geographical locations while communicating with each other to transfer data. This may not be always be possible to implement with some existing solutions.

In addition, existing solutions may require using fixed and/or default boundary conditions, such as functions/parameters, which may be inaccurate. The computation of these boundary conditions may be based on some fixed definition, which may not be applicable for all generic scenarios. Also, the existing solutions may not allow user defined functions (UDFs) and criteria/definitions for the boundary conditions to be added as plug-ins in the program structure of the two finite analysis solvers.

### SUMMARY

A system and method for bi-directional coupling of commercially available finite analysis solvers is disclosed. According to one aspect of the present subject matter, the method for bi-directional coupling of finite analysis solvers includes forming a first finite analysis model and a second finite analysis model, using user defined first and second boundary conditions respectively in a first finite analysis solver and a second finite analysis solver. Further, a task scheduling service (TSS) is configured based on the first and second finite analysis solver dependent boundary conditions for the first finite analysis solver and the second finite analysis solver. Furthermore, the second finite analysis solver dependent boundary conditions are computed by the first finite analysis solver, by performing finite analysis on the first finite analysis model, based on the first boundary conditions and frequency of coupling. Furthermore, the computed second finite analysis solver dependent boundary conditions are transferred by the TSS to the second finite analysis solver, along with a control signal to the second finite analysis solver. Furthermore, upon receipt of the control signal from the TSS, the second finite analysis solver computes the first finite analysis solver dependent boundary conditions by performing finite analysis on the second finite analysis model, based on the second boundary conditions and frequency of coupling. Furthermore, the TSS transfers the computed first finite analysis solver dependent boundary conditions to the first finite analysis solver, along with a control signal to the first finite analysis solver. Furthermore, these steps of computing, transferring, computing and transferring are repeated until a convergence is achieved between the first and second finite analysis solvers.

Also, a customized solver specific service is configured for the first finite analysis solver and another customized solver specific service is configured for the second finite analysis solver to monitor the tasks performed by the first finite analysis solver and the second finite analysis solver. These solver specific services, along with the task scheduling services removes any limitations in currently existing techniques / commercial software as described earlier.

According to yet another aspect of the present subject matter, a non-transitory computer storage medium for coupling commercially available finite analysis solvers having instructions that, when executed by a computing device, causes the computing device to perform the method described above.

These and other advantages of the present subject matter will be apparent from the accompanying drawings and from the detailed description that follows. The system and method disclosed herein may be implemented in any means for achieving various aspects.

### BRIEF DESCRIPTION OF THE DRAWINGS

Various embodiments are described herein with reference to the drawings, wherein:
**FIG. 1** shows a block diagram of a bi-directional coupling system, according to one embodiment of the present subject matter;
**FIG. 2** shows a schematic of a sequential coupling deployed between two finite analysis solvers, according to one embodiment of the present subject matter;
**FIG. 3** shows a flow chart of an exemplary method for bi-directional coupling of finite analysis solvers, according to one embodiment of the present subject matter; and
**FIG. 4** shows another flow chart for bi-directional coupling between the two finite analysis solvers, according to one embodiment of the present subject matter.

The drawings described herein are for illustration purpose only and are not intended to limit the scope of the present disclosure in any way.

### DETAILED DESCRIPTION

A system and method for bi-directional coupling of finite analysis solvers is disclosed. In the following detailed description of the embodiments of the present subject matter, references are made to the accompanying drawings that form a part hereof, and in which are shown by way of illustration specific embodiments in which the present subject matter may be practiced. These embodiments are described in sufficient detail to enable those skilled in the art to practice the present subject matter, and it is to be understood that other embodiments may be utilized and that changes may be made without departing from the scope of the present subject matter. The following detailed description is, therefore, not to be taken in a limiting sense, and the scope of the present subject matter is defined by the appended claims.

The terms "frequency of coupling" and "coupling time-step size", "are used interchangeably throughout the document. The terms "time-step" and "load step size" are specified as part of first and second boundary conditions and are smaller than the "coupling time-step size". The terms "solver dependent boundary condition", "new data", "load", "file load" are also used interchangeably throughout the document. The terms "finite analysis solver" and "FA solver" are also used interchangeably throughout the document. The terms "solver specific service", "customized solver specific service", "SSS" are also used interchangeably throughout the document.

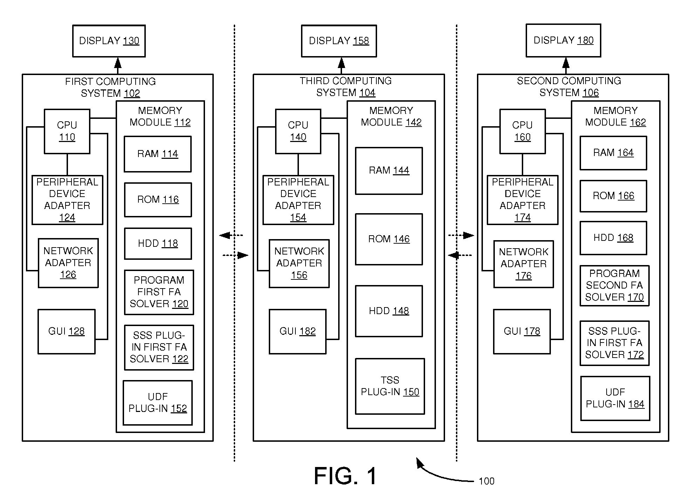

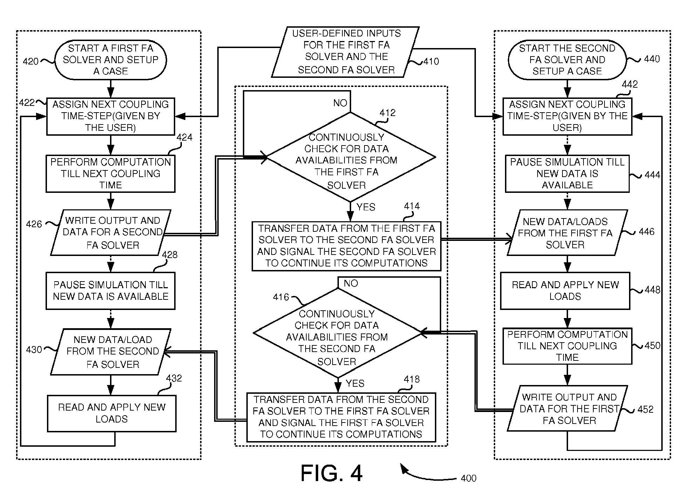

FIG. 1 shows block diagram 100 of a bi-directional system, according to one embodiment of the present subject matter. The system comprises of a first computing system 102, located at a first geographical location and/or based on a first computing platform, such as Windows™ or Linux™ which includes a CPU 110, a memory module 112, a display 130, a peripheral device adapter 124, a network adapter 126 and a graphical user interface 128. The memory module 112 further includes a RAM 114, a ROM 116, a HDD 118, a program resident in the memory module 112 for the first finite analysis solver (first FA solver) 120, and a solver specific service plug-in 122 for the first FA solver 120, which is also resident in the memory module 112. A user-defined plug-in for the first finite analysis solver may be included along with SSS plug-in. The system further comprises of a second computing system 106, located at a second geographical location and/or based on a second computing platform, such as Windows™ or Linux™ which includes a CPU 160, a memory module 162, a display 180, a peripheral device adapter 174, a network adapter 176 and a graphical user interface (GUI) 178. The memory module 162 further includes a RAM 164, a ROM 166, a HDD 168, a program resident in the memory module 162 for the second FA solver 170, and a solver specific service plug-in 172 for the second FA solver 170, which is also resident in the memory module 162. A user-defined plug-in for the second finite analysis solver may be included along with solver specific service (SSS) plug-in. The system further comprises of a third computing system 104 located at a third geographical location which includes a CPU 140, a memory module 142, a display 158, a peripheral device adapter 154, a network adapter 156 and a GUI 182. The memory module 142 further includes a RAM 144, a ROM 146, a HDD 148, a TSS plug-in 150, resident in the memory module 142, for scheduling the tasks to the two FA solvers,. The interaction between the SSS which is customized for the two FA solvers and the TSS150 are explained in detail with reference to FIG. 4. The third computing system 104 may interact with the first and second computing systems 102 and 106 via a shared location/folder in the network.

According to another embodiment of the present subject matter, the memory module 112 inside the first computing system 102 contains instructions for the operation of the customized solver specific service 122 inside the first computing system 102. Furthermore, the memory module 162 inside the second computing system 106 contains instructions for the operation of the customized solver specific service 172 inside the second computing system 106. Furthermore, the memory module 142 inside the third computing system 104 contains the instructions for the operation of the TSS 150 in the user computing system 104. The execution of instructions contained in its memory module 112 by the CPU 110 of the first computing system 102, the execution of instructions contained in its memory module 162 by the CPU 160 of the second computing system 106 and the execution of instructions contained in its memory module 142 by the CPU 140 of the third computing system 104 results are explained in detail with reference to FIG. 4.

The SSS 122 for the first FA solver 120 is customized for the first FA solver 120 and the tasks performed by the first FA solver 120 is monitored by the SSS 122 implemented in the first computing system 102. The first FA solver 120 is usually referred to as a lead solver. Example first FA solver 120 includes a CFD solver, such as Fluent®). The SSS 172 for the second FA solver 170 may be customized for the second FA solver 170 and the tasks performed by the second FA solver 170 is monitored by the SSS 172 implemented in the second computing system 106. Example second FA solver 170 includes a FEA-Thermal solver, such as Ansys Mechanical®. The TSS 150 implemented in the third computing system 104 controls the coupling between the two FA solvers and also provides the control signal to the two FA solvers to signal the availability of solution data (or load data for other solver). The user may specify time instances of coupling and time-step sizes of coupling for the two FA solvers in the SSS plug-ins. Flexibility may be added to have variable coupling time-step size. Further, the user defined inputs to the first and second FA solvers are specified in respective SSSs. The third computing system 104 checks the availability of new or customized data and transfers available data or other solvers, and signals to the other FA solvers to continue the simulation

The use of TSS 150 allows the FA solvers to be executed on different systems or different operating systems or different processors. In a case when one FA solver takes significantly longer time than the other FA solver to perform its computations, that FA solver can be executed on a system with parallel processors to speed up its computations. Also, when people of different groups or departments work on different types of finite analysis, they may need to run their respective FA solvers at different geographical locations as well. Also, for optimized simulation activity for the individual solvers, the two FA solvers may require significantly different mesh (difference typically in mesh size and element type) for their respective domains. The FA solvers may also have different computational hardware or platform requirements. Therefore, the FA solvers may need to run on different servers or different operating systems or different processors at different geographical locations while communicating with each other to transfer the solution data. The use of TSS allows all these possibilities. The TSS 150 continuously checks whether one of the FA solvers has generated the solution data or load files for the other FA solver. When load files have been generated by one of the FA solvers, the generated load files are transferred by the TSS 150, from the location or file system of that FA solver, to the location or file system of the other FA solver. The TSS 150 then signals the other FA solver that new load files have been transferred.

The use of customized solver specific service for the two FA solvers provides the advantage of any customized definition of the loads to be applied to or calculated by the two FA solvers to improve the accuracy of mapping between the two FA solvers. In some embodiments, mapping of loads based on user defined criteria or plug-in and performing coupling are performed irrespective of geographical/platform location. In a specific example, the first FA solver 120 (CFD solver Fluent®) writes the solution data to be used by a thermal model in the second FA solver 170 (FEA solver Ansys Mechanical®). The solution data can be in any form such as convective loads (heat transfer coefficient-reference temperature combination (or HTC-Tref combination) or Heat Flux or Heat Rates) on the wetted interfaces for the thermal model in Ansys Mechanical®, pressure or force data causing displacement of nodes in a structural model, or temperature data to be used for thermal stress analysis in a finite element (FE) model. In turn, the second FA solver 170 (Ansys Mechanical®) writes the solution data to be used by a CFD model in the first FA solver 120. The solution data can be in any form such as temperature loads on the wetted interfaces, or nodal displacements, or heat rate or flux to be used by the CFD model in the first FA solver (Fluent®). Accuracy in coupling process can be improved by using customized definition of solution data like HTC and Tref as specified by the user.

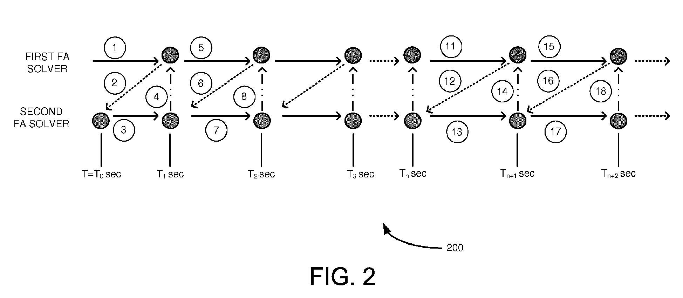

Referring now to **FIG. 2**, it shows a schematic of a sequential coupling 200 deployed between two finite analysis solvers, according to one embodiment of the present subject matter. The sequential coupling of the present subject matter allows the user to specify the time instances at which the coupling is to be performed and time-step sizes of each coupling step. Ideally, the two FA solvers should be coupled as frequently as possible to improve the coupling efficiency. However, this is practically not possible as it increases the computational cost significantly. Therefore, to optimize between efficiency and cost, it may be required to couple the FA solvers more frequently at the start of simulations, while later on the frequency of coupling may be reduced for better management of computational resources. Hence, the time instances for performing the coupling and the coupling frequency or time-step sizes for the different coupling steps may need to be time-variant or flexible as per the user requirement. As shown in FIG.2, the time instances for performing the coupling are transient or varying for various stages of the simulation. Further, it can be seen that the time-step size ΔT₁ = (T₁ - T₀) = (T₂ - T₁) etc for initial stage of simulation is not the same as the time-step size ΔT₂ = (Tₙ₊₁ - Tₙ) = (Tₙ₊₂ - Tₙ₊₁) etc for a later stage of simulation. The time-step sizes in step (1), step (5), and so on are not the same as the time-step sizes in steps (11) and (15), etc for the first FA solver 120, at various stages of simulation. Similarly, the time-step sizes in step (3), step (7), etc are not the same as the time-step sizes in steps (13), step (17), etc for the second FA solver 170, at various stages of simulation. The use of customized solver specific services (SSS) for the two FA solvers permits the coupling process to be applied for both transient simulation (as in the present subject matter) and steady state simulation (as in prior art systems).

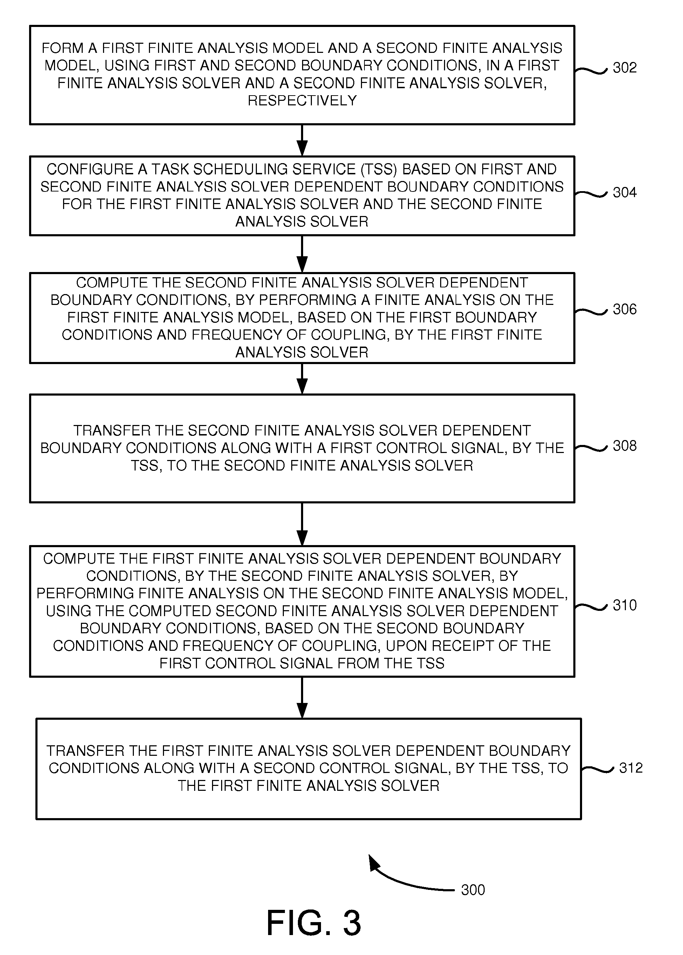

Referring now to **FIG. 3**, it shows a flow chart 300 of an exemplary method for bi-directional coupling of finite analysis solvers, according to one embodiment of the present subject matter.

At step 302, a first finite analysis model and a second finite analysis model are formed using first and second boundary conditions in the first FA solver 120 and the second FA solver 170, respectively. The setup of the first FA solver 120 and the second FA solver 170 is performed by the respective customized solver specific service (SSS) interfaces as explained earlier with reference to FIG. 1. This step also involves setup of user-defined functions and it's plug-in for the solver(s). The plug-in for UDF can be setup separately or can be included within the SSS itself for a given solver.

The first and second boundary conditions include user defined values for time instances at which coupling is to be performed and the size of coupling time-steps, customized solver dependent boundary conditions, such as UDF, which is the solution data or load files coming from the other solver, customized solver independent boundary conditions, which are inputs required for performing simulation on the two finite analysis models, and customized solver dependent user defined functions and criteria.

At step 304, configures a TSS based on the first and second FA solver dependent boundary conditions for the first finite analysis solver and the second finite analysis solver. The tasks performed by the TSS have been explained earlier with reference to FIG. 1.

At step 306, the second FA solver dependent boundary conditions are computed, by performing the finite analysis on the first finite analysis model, based on the first boundary conditions and frequency of coupling. The tasks performed by the first FA solver are monitored by the customized solver specific service (SSS) 122 for the first FA solver which has been explained earlier with respect to FIG. 1. The dependent boundary conditions for the second FA solver 170 is the solution data or file loads that will be mapped from the first FA solver 120.

At step308, the second FA solver dependent boundary conditions (solution data or file loads) are transferred by the TSS to the second FA solver along with a first control signal to the second FA solver upon computing the second FA solver dependent boundary conditions.

At step 310, the first FA solver dependent boundary conditions are computed by the second FA analysis solver, by performing the finite analysis on the second FA model using the computed second finite analysis solver dependent boundary conditions, based on second boundary conditions and frequency of coupling upon receipt of the first control signal from the TSS. The tasks performed by the second FA solver 170 is monitored by the customized solver specific service (SSS) 172 for the second FA solver 170 which has been explained earlier with respect to FIG. 1. The dependent boundary conditions for the first FA solver 120 is the solution data or file loads that will be mapped from the second FA solver 170.

At step 312, the first FA solver dependent boundary conditions (solution data or file loads) are transferred by the TSS to the first FA solver, along with a second control signal to the first FA solver upon computing the first FA solver dependent boundary conditions.

Steps 306 to 312 are repeated automatically until a convergence is achieved between the first and second FA solvers.

The interaction between the customized solver specific service (SSS) of the two FA solvers and the TSS is responsible for the execution of process steps 302 to 312. This will now be explained in more detail with reference to FIG. 4.

Referring now to **FIG. 4**, it shows another flow chart 400 for coupling between the two FA solvers (120,170), according to one embodiment of the present subject matter. The double solid lines represent the data transfer from one solver to another solver using the TSS 150. The tasks performed by the TSS 150 have been explained earlier with respect to FIG. 1. The dotted arrows represent the halt in the corresponding solver simulations till new data from the other solver is received. As explained earlier with reference to FIG. 1, the tasks performed by the first FA solver 120 are monitored by the customized solver specific service (SSS) 122 for the first FA solver 120. Similarly, the tasks performed by the second FA solver 170 are monitored by the customized solver specific service (SSS) 172 for the second FA solver 170. The interaction between the SSS 122 of first FA solver 120, TSS 150 and SSS 172 of the second FA solver 170 controls the coupling between the two FA solvers (120,170). At step 420, the SSS 122 of the first FA solver 120 starts the first FA solver 120 and completes the setup of the first FA solver 120. Simultaneously, at step 440, the SSS 172 of the second FA solver 170 starts the second FA solver 170 and completes the setup of the second FA solver 170. At step 410, the user provides user-defined inputs for both the FA solvers. The user-defined inputs comprise of time instance value for starting the coupling, the time-step size of the coupling and customized functions or criteria for improving the accuracy of coupling (e.g. computing loads based on user-defined criteria/functions). The SSS (122,172) of the two FA solvers (120,170) read all the user inputs and prepare the two FA solvers (120,170) for their respective computations. At step 422, the SSS 122 of the first FA solver 120 assigns the next coupling time-step given by the user to the first FA solver 120. Simultaneously, at step 442, the SSS 172 of the second FA solver 170 assigns the next coupling time-step given by the user to the second FA solver 170. At step 424, the SSS 122 of the first FA solver 120 instructs the first FA solver 120 to perform its computations till the next coupling time instance specified by the user. During this time, the SSS 172 of the second FA solver 170 instructs the second FA solver 170 to wait for new data from the first FA solver 120 as shown at step 444. At step 426, the SSS 122 of the first FA solver 120 writes the solution data to be mapped on to the second FA solver 170. This data can be based on user-defined criteria, integrated in user-defined plug-in for this solver, which improves the accuracy of the coupling process. At step 412, the TSS 150 is continuously or iteratively checking for availability of the solution data from the SSS 122 of the first FA solver 120. If no data is available, the checking continues in a loop. When the solution data is available from the SSS 122 of the first FA solver 120, the TSS 150 transfers the solution data to the SSS 172 of the second FA solver 170 as at step 414, along with the first control signal to the SSS 172 of the second FA solver 170 to instruct the second FA solver 170 to continue its computations. At step 446, the SSS 172 of the second FA solver 170 is receiving the new loads from the SSS 122 of the first FA solver 120 (through the TSS 150). At step 448, the SSS 172 of the second FA solver 170 instructs the second FA solver 170 to read and apply the new loads. At step 450, the SSS 172 of the second FA solver 170 instructs the second FA solver 170 to perform its computations till the next coupling time instance specified by the user. During this time, the SSS 122 of the first FA solver 120 instructs the first FA solver 120 to wait for new data from the SSS 172 of the second FA solver 170 through the TSS 150 as shown at step 428. At step 452, the SSS 172 of the second FA solver 170 writes the solution data to be mapped on to the first FA solver 120. Again, this data can be based on user-defined criteria, integrated in the user-defined plug-in for this solver, which improves the accuracy of the coupling process. At step 416, the TSS 150 is continuously checking for availability of solution data from the second FA solver 170. If no data is available, the checking continues in a loop. When the solution data is available from the SSS 172 of the second FA solver 170, the TSS 150 transfers the solution data to the SSS 122 of the first FA solver 120 as at step 418, along with the second control signal to the SSS 122 of the first FA solver 120 to instruct the first FA solver 120 to continue its computations. At step 430, the SSS 122 of the first FA solver 120 is receiving the new loads from the SSS 172 of the second FA solver 170 (through the TSS 150). At step 432, the SSS 122 of the first FA solver 120 instructs the first FA solver 120 to read and apply the new loads. After the first FA solver 120 reads and applies the new loads at step 432, the SSS 122 of the first FA solver 120 loops back to step 422 and reads the next coupling time-step data from the user. After this, the SSS 122 of the first FA solver 120 instructs the first FA solver 120 to once again perform its computations. Similarly, after step 452, the SSS 172 of the second FA solver 170 loops back to step 442 and reads the next coupling step data from the user. After this, the SSS 172 of the second FA solver 170 instructs the second FA solver 170 to be ready for performing the next cycle of operations. Coupling between the two FA solvers (120,170) continues automatically as explained above, until the two FA solvers (120,170) reach the end of their simulations. It is to be noted that the solver specific service SSS is customized for each FA solver and is not identical for both the FA solvers.

The use of SSS permits the coupling process explained above to be applied for any type of FA solvers for performing different types of analysis (for example fluid-structural coupling, thermal-mechanical coupling, etc) provided the FA solvers allow customization, using command line approach or scripting in addition to GUI (graphical user interface) based approach, to perform specific tasks as desired by the user.

The above bi-directional coupling technique provides a significantly improved accuracy with respect to uncoupled standalone simulations. Further, the above technique provides a robust coupling process to accurately predict the performance of a system and a completely automated coupling process after initial setup. Furthermore, the above technique facilitates execution of the solvers on different systems or operating systems or processors at different geographical locations. In addition, the above technique allows performing bi-directional coupling at different time instances with varying time-step sizes. Also, the above technique allows use of customized definition of loads to improve the accuracy of mapping. Moreover, the above technique allows mapping of different kinds of loads for different solvers or for different types of finite analysis and further allows performing of both transient and steady state simulations.

Although the coupling method of the present subject matter is illustrated with two FA solvers, it can be applied to any number of FA solvers running on the same or different systems.

Although certain methods and systems have been described herein, the scope of coverage of this application is not limited thereto. To the contrary, this application covers all methods and systems fairly falling within the scope of the appended claims either literally or under the doctrine of equivalents.

## Claims

1. A method for bi-directional coupling of finite analysis solvers for multi-disciplinary simulations comprising:
forming a first finite analysis model and a second finite analysis model, using first and second boundary conditions, in a first finite analysis solver and a second finite analysis solver, respectively, wherein the first finite analysis solver and the second finite analysis solver are of different discipline;
configuring a task scheduling service (TSS), based on first and second finite analysis solver dependent boundary conditions for the first finite analysis solver and the second finite analysis solver;
computing second finite analysis solver dependent boundary conditions, by performing a finite analysis on the first finite analysis model, based on the first boundary conditions and frequency of coupling, by the first finite analysis solver;
transferring the second finite analysis solver dependent boundary conditions, by the TSS, to the second finite analysis solver, along with a first control signal to the second finite analysis solver, upon computing the second finite analysis solver dependent boundary conditions;
computing first finite analysis solver dependent boundary conditions, by the second finite analysis solver, by performing finite analysis on the second finite analysis model, using the computed second finite analysis solver dependent boundary conditions, based on second boundary conditions and frequency of coupling, upon receipt of the first control signal from the TSS; and
transferring the first finite analysis solver dependent boundary conditions, by the TSS, to the first finite analysis solver, along with a second control signal to the first finite analysis solver, upon computing the first finite analysis solver dependent boundary conditions.

2. The method of claim 1, repeating the steps of computing, transferring, computing and transferring until a convergence is achieved between the first and second finite analysis solvers.

3. The method of claim 1, wherein the first and second boundary conditions comprises boundary conditions selected from the group consisting of user defined frequency of coupling, customized solver independent boundary conditions and customized solver dependent boundary conditions.

4. The method of claim 1, wherein the first finite analysis solver and the second finite analysis solver are selected from the group consisting of CFD solver and FEA solver.

5. The method of claim 1, wherein the boundary conditions are solver dependent boundary conditions or independent boundary conditions.

6. A system for bi-directional coupling of finite analysis solvers for multi-disciplinary simulations comprising:
a first computing system comprising:
a first processor; and
a first memory coupled to the first processor;
a second computing system comprising:
a second processor; and
a second memory coupled to the second processor; and
a third computing system comprising:
a third processor; and
a third memory, wherein the first memory, the second memory and the third memory includes a first finite analysis solver and a first solver specific service module, a second finite analysis solver and a second solver specific service module and a task scheduling service (TSS) module, respectively, having instructions to:
form a first finite analysis model and a second finite analysis model, using first and second boundary conditions in the first computing system and second computing system, respectively, wherein the first finite analysis solver and the second finite analysis solver are of different discipline;
configure a TSS, based on first and second finite analysis solver dependent boundary conditions for the first finite analysis solver and the second finite analysis solver;
compute second finite analysis solver dependent boundary conditions, by performing a finite analysis on the first finite analysis model, based on the first boundary conditions and frequency of coupling;
transfer the second finite analysis solver dependent boundary conditions, by the TSS, to the second finite analysis solver, along with a first control signal to the second finite analysis solver, upon computing the second finite analysis solver dependent boundary conditions;
compute first finite analysis solver dependent boundary conditions, by the second finite analysis solver, by performing finite analysis on the second finite analysis model, using the computed second finite analysis solver dependent boundary conditions, based on second boundary conditions and frequency of coupling, upon receipt of the first control signal from the TSS; and
transfer the first finite analysis solver dependent boundary conditions, by the TSS, to the first finite analysis solver, along with a second control signal to the first finite analysis solver, upon computing the first finite analysis solver dependent boundary conditions.

7. The system of claim 6, wherein the steps of computing, transferring, computing and transferring are repeated until a convergence is achieved between the first and second finite analysis solvers.

8. A non-transitory computer storage medium for bi-directional coupling of finite analysis solvers for multi-disciplinary simulations having instructions that, when executed by a computing device causes the computing device to:
form a first finite analysis model and a second finite analysis model, using first and second boundary conditions, in a first finite analysis solver and a second finite analysis solver, respectively, wherein the first finite analysis solver and the second finite analysis solver are of different discipline;
configure a TSS, based on first and second finite analysis solver dependent boundary conditions for the first finite analysis solver and the second finite analysis solver;
compute second finite analysis solver dependent boundary conditions, by performing a finite analysis on the first finite analysis model, based on the first boundary conditions and frequency of coupling, by the first finite analysis solver;
transfer the second finite analysis solver dependent boundary conditions, by the TSS, to the second finite analysis solver, along with a first control signal to the second finite analysis solver, upon computing the second finite analysis solver dependent boundary conditions;
compute first finite analysis solver dependent boundary conditions, by the second finite analysis solver, by performing finite analysis on the second finite analysis model, using the computed second finite analysis solver dependent boundary conditions, based on second boundary conditions and frequency of coupling, upon receipt of the first control signal from the TSS; and
transfer the first finite analysis solver dependent boundary conditions, by the TSS, to the first finite analysis solver, along with a second control signal to the first finite analysis solver, upon computing the first finite analysis solver dependent boundary conditions.

9. The non-transitory computer storage medium of claim 8, wherein the steps of computing, transferring, computing and transferring are repeated until a convergence is achieved between the first and second finite analysis solvers.

10. The method of claim 1, wherein the first finite analysis solver is CFD solver and the second finite analysis solver is FEA solver or vice versa.
